# EUROPEAN PATENT APPLICATION

(11) **EP 1 898 495 A1**
(43) Date of publication of application: **12.03.2008**
(21) Application number: 06746572.4
(22) Date of filing: 11.05.2006
(51) Int. Cl.: H01R 11/01, H05K 1/02, H01B 5/16

(54) **POROUS RESIN BASE, METHOD FOR MANUFACTURING SAME, AND MULTILAYER SUBSTRATE**

(30) Priority: 27.06.2005 JP 2005187096
(71) Applicant: Sumitomo Electric Industries, Ltd., Osaka-shi, Osaka 541-0041 (JP)
(72) Inventor: IDOMOTO, Yuichi, Sumitomo Electric Industries, Ltd, Osaka-shi, Osaka 554-0024 (JP); OKUDA, Yasuhiro, Sumitomo Electric Industries, Ltd, Osaka-shi, Osaka 554-0024 (JP)
(74) Representative: Cross, Rupert Edward Blount
(86) International application number: PCT/JP2006/309873
(87) International publication number: WO 2007/000855

(57) **Abstract**

A porous resin substrate and a manufacturing method thereof. The substrate comprises a porous resin film having at least one functional part including electrodes or circuits, or both of them, and the porous resin film has a height-altered part, the height of which is different from the height of the functional part.

## Description

### Technical Field

The present invention relates to a porous resin substrate and a method of manufacturing the same. In particular, the porous resin substrate of the present invention includes a functional part having electrodes and/or circuits formed in a porous resin film and a height-altered part formed in the porous resin film such that the height level thereof is different from the height level of the functional part. The porous resin substrate of the present invention is structured, for example, such that the functional part including electrodes and/or circuits is protruded.

For example, the porous resin substrate of the present invention can suitably be used for various connectors or interposers as an anisotropic conductive film which is used to make an electrical connection between two circuit devices, or an anisotropic conductive film which is used to perform an electrical inspection of a printed circuit board or a circuit device such as a semiconductor integrated circuit device (for example, semiconductor chip), etc. The term "electrode and/or circuit" as used in the present invention means an electrode or a circuit, or both of them.

### Background Art

In Japanese Patent Application Publication No. 2004-265844 (hereinafter, referred to as "Document 1"), a method of forming a conductive part is disclosed, which method comprises a step of providing a plurality of through holes in a thickness direction from a first surface to a second surface at a plurality of positions in a porous resin film having an electrical insulation property and used as a base film and a step of adhering conductive metal to a resin portion of the inner wall surface of each through hole so as to form a conductive part.

According to the method described in Document 1, it is possible to obtain an anisotropic conductive film having a plurality of conductive parts formed in the thickness direction in a porous resin film. That is, each conductive part is provided independently in the matrix of the porous resin film having an electrical insulation property such that conduction in the film thickness direction is possible but there is no conduction or short circuit between the respective conductive parts.

The conductive part is made by applying an electroless plating or the like so as to adhere conductive metal to the resin portion constituting a porous structure of the inner through hole wall surface, and it may be called a "tubular electrode" because of its shape. The tubular electrode is one kind of a through-electrode. By controlling the adhering quantity of the conductive metal, the conductivity in the film thickness direction of the tubular electrode can be controlled. Generally, the conduction is achieved by compressing the porous resin substrate in its entirety including the tubular electrodes by applying a load in the film thickness direction.

This anisotropic conductive film has resiliency in the film thickness direction and can be made to exhibit conductive property in the film thickness direction by application of low compressive loading. It is possible to make the size and pitch of the conductive parts of the anisotropic conductive film to be fine. The anisotropic conductive film, which has resiliency in the film thickness direction and in which the electrical conduction in the film thickness direction can be achieved with the application of low compressive loading, can be used as an anisotropic conductive film for the inspection of a semiconductor integrated circuit device, for example, and the film thickness can be recovered thanks to the resiliency even if the application of such loading is repeated, which enables the repeated use for such inspection.

More specifically, in order to perform an electrical inspection of a circuit device such as a semiconductor integrated circuit device (e.g., semiconductor chip) or a printed circuit board, it is necessary to correctly connect each electrode of such a circuit device with the corresponding electrode of electrical inspection equipment respectively. The electrical inspection includes a conduction inspection to determine whether or not the connection in the conductor pattern of the circuit device is achieved as designed and an electrical inspection for measuring the electrical resistance of a conductor, the characteristic impedance or the insulation resistance between conductors.

However, since the electrodes of the electrical inspection equipment are arranged generally on a rigid substrate, there have been problems such as difficulty in achieving connections between each electrode of the circuit device and each electrode of the electric inspection equipment correctly corresponding to each other, or the electrodes tend to suffer from damage due to mutual contact between the respective electrodes.

Therefore, a preventive method is adopted in which the respective electrodes are electrically connected through an anisotropic conductive film interposed between the electrode region of the circuit device and the electrode region of the electrical inspection equipment. The anisotropic conductive film is provided with a plurality of conductive parts in which conduction is possible only in the thickness direction. The conductive part is called a conducting part or an electrode.

The porous resin substrate disclosed in Document 1 can be used as an anisotropic conductive film to perform the electrical inspection of the circuit device. In this case, the positional relationship of the porous resin substrate is set and fixed such that each electrode (conductive part) of the circuit device and each electrode of the electrical inspection equipment can be correctly connected, respectively.

When the porous resin substrate is arranged between the semiconductor integrated circuit device (e.g., semiconductor chip) and the circuit board such as a printed circuit board, the porous resin substrate can function as a kind of connector or interposer which has stress relaxation and conduction properties.

The porous resin substrate must have such a degree of thickness as to enable the stress relaxation and resiliency in the film thickness direction. On the other hand, the porous resin substrate must be fixed when it is used so as to be interposed between the electrode region of the circuit device and the electrode region of the electrical inspection equipment or between the electrode region of the semiconductor integrated circuit device and the electrode region of the circuit board. In order to fix in such a manner, the porous resin substrate must have a shape which extends beyond the area of the electrode regions of such devices and equipment.

If the area of the porous resin substrate is made wider, in order to achieve conduction by compressing, it is necessary to apply a load to the circumferential region where no electrodes exist, as well as to a functional part (functional region) where a plurality of electrodes (conductive part) are formed. Therefore, there have been cases in which, to achieve conduction, loading must be applied to the porous resin substrate more than necessary, resulting in poor efficiency. Also, there have been shortcomings of the porous resin substrate having circuits formed on the surface of the porous resin film: the circuits of the porous resin films might contact each other when the porous resin substrates are stacked in multiple layers so that they may be formed into a multilayer substrate.

### Disclosure of Invention

A problem to be solved according to the present invention is to provide a porous resin substrate having a functional part in which an electrode and/or circuit are formed in the porous resin film, the porous resin substrate being structured such that the conduction thereof can be achieved by application of low loading so as not to degrade the properties, such as resiliency and conductance, of the porous resin substrate, or without application of loading to the part which does not include such functional part. Another problem is to provide a manufacturing method of the porous resin substrate.

Yet another problem to be solved according to the present invention is to provide a porous resin substrate in which circuits are formed on the surface of the porous resin film and which is structured such that when a multilayer substrate is formed by stacking the porous resin substrates, the mutual contact of the circuits can be prevented.

As a result of intensive studies, the inventors of the present invention found a way to solve the problems, that is, an idea of forming a height-altered part, which has a height level different from the height level of the functional part, in a porous resin substrate having a functional part in which electrodes and/or circuits are provided. For example, the height-altered part can be formed around a functional part in which electrodes are formed such that the height-altered part has a height level that is lower than the height level of the functional part. Circuits can be formed not only on the functional part but also on the height-altered part having a height level lower than the height level of the functional part. The height of the functional part may be made lower than the height of the circumjacent part.

For forming a height-altered part in a porous resin film, a heat pressing method may be adopted, for example. In the porous resin film, a height level difference can easily be formed by the heat pressing. By heat pressing the porous resin film, the heat pressed part becomes dense, but the functional part having electrodes and/or circuits does not suffer from deformation in the thickness or shape due to formation of a height-altered part. It is possible to make the height-altered part to have the desired shape and height level difference by controlling the heat press conditions including the shape of a mold for the heat press. The functional part should be formed preferably after the height-altered part is provided in the porous resin film.

The porous resin substrate in which the height-altered part is provided can be made to have a protruding functional part, for example, in which electrodes and/or circuits are provided. Therefore, it is possible to obtain conduction efficiently with low loading only by compressing the functional part. If the circuit is formed extending from the functional part to the height-altered part, the thus extending circuit can be prevented from inadvertent mutual contact between the circuits when a plurality of porous resin substrates are stacked to form a multilayer substrate. The present invention is completed based on such knowledge.

### Means for solving the problems to be solved

The present invention provides a porous resin substrate which comprises a porous resin film having at least one functional part including electrodes or circuits, or both of them, where the porous resin film has a height-altered part, the height of which is different from the height of the functional part.

Also, the present invention provides a multilayer substrate which is made by stacking a plurality of porous resin substrates.

Furthermore, the present invention provides a method of manufacturing a porous resin substrate in which a height-altered part having a height different from the height of a functional part of a porous resin film is formed, the method comprising: Step 1 of forming by a heat pressing method the height-altered part in an area around the region to constitute the functional part, the height-altered part having a height lower than the height of the region to constitute the functional part, or forming by the heat pressing method a region having a height lower than the height of the neighboring region in a region to constitute the functional part; and Step 2 of forming electrodes or circuits or both of them in the region to constitute the functional part.

Still furthermore, the present invention provides a method of manufacturing a porous resin substrate, the method comprising heat pressing by a heat pressing method the porous resin substrate made of a porous resin film so as to form a height-altered part in an area around a functional part, the porous resin film including at least one functional part having electrodes or circuits or both of them.

### Brief description of the drawings

Figure 1 is a schematic flow diagram showing an example of a process of manufacturing a porous resin substrate of the present invention.
Figure 2 is a schematic diagram showing an example of the relationship between the height of the functional part and the height of the height-altered part of a porous resin substrate of the present invention.
Figure 3 shows an example of the structure of a porous resin substrate of the present invention on which circuits are provided extending onto a height-altered part.
Figure 4 is a diagram showing a method of forming a height-altered part by heat pressing.

### Best mode for carrying out the Invention

### 1. Porous resin film (Base film)

An anisotropic conductive film for a burn-in test of a semiconductor integrated circuit device or the like should preferably be superior in terms of heat resistance properties of the base film. The anisotropic conductive film must be electrically insulative in the transverse direction (i.e., the direction perpendicular to the film thickness direction). Therefore, the synthetic resin for forming the base film of a porous resin substrate must have an electrical insulation property.

The synthetic resin material for forming a porous resin film used as a base film is, for example, fluororesin such as polytetrafluoroethylene (PTFE), tetrafluoroethylene/hexafluoropropylene copolymer (FEP), tetrafluoroethylene/perfluoroalkylvinylether copolymer (PFA), polyvinylidene fluoride (PVDF), polyvinylidene fluoride copolymer, ethylene/tetrafluoroethylene copolymer (ETFE resin); engineering plastics such as polyimide (PI), polyamide-imide (PAI), polyamide (PA), denatured polyphenylene ether (mPPE), polyphenylene sulfide (PPS), polyether etherketone (PEEK), polysulfone (PSU), polyethersulfone (PES), liquid crystal polymer (LCP); or the like.

Of these synthetic resin materials, the fluororesin is preferable from the viewpoint of heat resistance, processability, mechanical characteristics, dielectric property, etc. and in particular polytetrafluoroethylene (PTFE) is preferable.

Examples of methods for preparing the porous resin film consisting of synthetic resin include pore-forming method, phase separation method, solvent extraction method, drawing method, laser irradiation method, etc. Of these methods, the drawing method is preferable from the viewpoint of ease in controlling the mean pore size and porosity. By forming a porous resin film using the synthetic resin, it is made possible to provide resiliency in a film thickness direction and to lower the dielectric constant.

The porous resin film used as the base film of an anisotropic conductive film preferably has a porosity (ASTM D-792) of about 20 to 80 %. The porous resin film preferably has a mean pore size of 10 µm or less and a bubble point (measured using isopropylalcohol according to ASTM-F-316-76) of 2 kPa or more, and from the viewpoint of achieving a fine pitch of a conductive part, the mean pore size is preferably 5 µm or less, and more preferably 1 µm or less. The minimum value of the mean pore size is about 0.05 µm. The bubble point of the porous resin film is preferably 5 kPa or more, and more preferably 10 kPa or more. The upper limit value of the bubble point is about 300 kPa, but not limited to this.

It is possible to choose the film thickness of the porous resin film according to the purpose and the place of its use. The film thickness is generally 20 to 3000 µm, preferably 25 to 2000 µm, and more preferably 30 to 1000 µm. Accordingly, the thickness of the porous resin film includes both regions of film (less than 250 µm) and sheet (250 µm or more). If the film thickness of the porous resin film is too thin, it becomes difficult to form a height-altered part with the desired height.

Of the porous resin film, a porous polytetrafluoroethylene film (hereinafter, abbreviated to an "expanded porous PTFE membrane") obtained by the drawing method is a most excellent material as the base film of an anisotropic conductive film because it has superior properties with respect to heat resistance, processability, mechanical characteristics, dielectric property, etc. and because it is easy to obtain uniform pore size distribution of the porous resin film. The expanded porous PTFE membrane has fine structure (porous structure) consisting of a number of fibrils and a number of nodes connected by the fibrils, and it is possible to adhere conductive metal such as plating particles to the fibrils.

The expanded porous PTFE membrane to be used in the present invention can be manufactured by the method described in Japanese patent publication of examined application No. S42-13560, for example. First, polytetrafluoroethylene unsintered powder is mixed with a liquid lubricant and is extruded by ram extrusion into a tubular or board-shaped form. For obtaining a sheet having a thin thickness, the board-shaped body is subjected to rolling by a rolling mill roller. After the extrusion and rolling process, if it is needed, the liquid lubricant is removed from the extruded or rolled product. When the extruded or rolled product is drawn at least in one uniaxial direction, an unsintered expanded porous PTFE membrane is obtained in a film form. An expanded porous PTFE membrane having high strength can be obtained if the expanded structure of the unsintered expanded porous PTFE membrane is sintered and fixed at a temperature equal to or more than 327 °C, which is the melting point of PTFE, while it is fixed so as not to cause contraction. In the case where the expanded porous PTFE membrane has a tubular form, it can be cut open into a flat film.

The expanded porous PTFE membrane has a microstructure consisting of extremely fine fibrils and nodes interconnected by the fibrils, which are respectively formed of PTFE. In the expanded porous PTFE membrane, this microstructure forms a porous structure.

### 2. Porous resin substrate in which electrodes and/or circuits are formed

In the case where the porous resin substrate in which electrodes are formed is used as an anisotropic conductive film, it is preferable to form through holes piercing in a thickness direction from a first surface to a second surface at a plurality of positions in a base film consisting of an electrically insulative porous resin film made of synthetic resin, and subsequently to form independently a plurality of conductive parts (tubular electrodes) which can give conductivity in a thickness direction, by adhering conductive metal to the resin portion (e.g., fibrils of the expanded porous PTFE membrane) of the porous structure in the inner wall surface of each through hole. The adhering of the conductive metal can be performed generally by a method in which plating particles are adhered to the resin portion of the porous structure in the inner wall surface of each through hole by means of electroless plating or the combination of electroless plating and electrolytic plating.

The method of providing a plurality of through holes in the thickness direction of the porous resin film and the method of forming conductive parts (tubular electrodes) by adhering the conductive metal to the wall surface of the through holes are, for example, the methods as described below, but not particularly limited to them.

An example of manufacturing method for the porous resin substrate includes, for example, the following Steps 1 to 5:
(a) Step 1 in which a three layer laminated body is formed by laminating a resin layer as a mask layer on the surface of both sides of a porous resin film;
(b) Step 2 in which a plurality of through holes piercing in the thickness direction are formed in the laminated body;
(c) Step 3 in which a catalyst for facilitating the reduction reaction of metal ions is adhered to the surface of the laminated body including the inner wall surface of the through holes;
(d) Step 4 in which the mask layer is peeled off from the porous resin film; and
(e) Step 5 in which conductive metal is adhered using the catalyst to the resin portion of the inner wall surface of the through holes.

A resin material is preferably used as a material of the mask layer. In the case where a porous fluororesin film is used as the porous resin film, it is preferable to use the same kind of porous fluororesin film as the mask layer, but it is also possible to use a fluororesin nonporous film and a nonporous or porous resin film consisting of a resin material other than the fluororesin. An adhesion tape or sheet can be used as a material of the mask layer. From the viewpoint of balance in terms of the adhesiveness and peel property between the layers, it is preferable to use, for the material of the mask layer, a porous resin film having the same quality as that of the porous resin film.

A mask layer is arranged on the surface of both sides of the porous resin film, and three layers are united by fusion-bonding, for example. In the case where an expanded porous PTFE membrane is used as the porous resin film, it is preferable to use the same kind of expanded porous PTFE membrane for the mask layer. These three layers can be formed into a laminated body in which the layers are fusion-bonded by heat pressing them. This laminated body can easily be delaminated in a subsequent step.

A plurality of through holes are formed in the thickness direction in the laminated body. Examples of methods for forming a through hole include: i) mechanical perforation, ii) etching by light ablation, and iii) perforation by means of ultrasonic wave energy applied by pressing the tip of one or more oscillators provided at the tip portion of an ultrasonic head.

For performing mechanical perforation, machining methods, for example, such as pressing, punching, and drilling can be adopted. According to a machining method, it is possible to form, at low cost, through holes having a comparatively large diameter, for example, 100 µm or more, in many cases 200 µm or more, and furthermore 300 µm or more. Through holes having a smaller diameter than those mentioned above can also be formed by such machining method.

For forming a through hole by means of a light ablation method, it is preferable to adopt the method of forming a plurality of through holes in a pattern by irradiating light onto the surface of a laminated body through a light shielding sheet (mask) having a plurality of light transmitting parts (opening) each independently provided in a pre-determined pattern. Light penetrates through a plurality of opening of the light shielding sheet, and thereby the irradiated points of the laminated body are etched to form through holes. According to this method, it is possible to form through holes having a comparatively small diameter, for example, 10 to 200 µm, in many cases 15 to 150 µm, and moreover 20 to 100 µm. The examples of irradiation light of the light ablation method include synchrotron radiation beams and laser beams.

According to the ultrasonic wave method, ultrasonic wave energy is applied using an ultrasonic head having at least one oscillator provided at the tip portion thereof, and thereby a plurality of through holes are formed in a pattern. Ultrasonic wave energy is applied only to the vicinity which the tip of the oscillator has touched, and thereby the temperature rises locally due to the vibration energy caused by the ultrasonic wave, so that the resin is easily cut off to form a through hole.

On the occasion of forming a through hole, it is possible to adopt a method in which a solution or melt of soluble polymer such as polymethylmethacrylate or paraffin is impregnated in the porous structure of the porous resin film and solidified and thereafter the perforation is performed. This method is preferable because it makes easy to maintain the porous structure in the wall of the through hole. After the perforation, the soluble polymer or the paraffin can be removed by dissolving or melting. This method is particularly effective when an expanded porous PTFE membrane is used.

The through hole can have an optional shape: circular, elliptical, stellar, octagonal, hexagonal, square, triangle, etc. The diameter of the through hole is generally 5 to 100 µm in the application field where a small diameter through hole is suited, and can be further decreased to 5 to 30 µm. On the other hand, in the field where the through hole having a comparatively large diameter is suited, the diameter of the through hole can be made generally as large as 50 to 3000 µm, in many cases 75 to 2000 µm, and furthermore 100 to 1500 µm. Preferably, a plurality of through holes are formed, for example, in a pre-determined pattern according to the distribution of the electrodes (the number and arrangement pitch of electrodes) of the circuit device such as a semiconductor integrated circuit device, a printed circuit board, or the like.

If a catalyst (hereinafter, occasionally called the "plating catalyst") for facilitating the reduction reaction of the metal ion is to be adhered to the surface of a laminated body including the inner wall surface of the through hole, the laminated body may be immersed in, for example, a palladium-tin colloidal catalyst added solution which is sufficiently stirring. Using the remaining catalyst adhering to the wall surface of the through hole, conductive metal may selectively be adhered to the wall surface. Examples of methods for adhering the conductive metal include electroless plating method, sputtering method, conductive metal paste coating method, etc. Of these methods, the electroless plating method is preferable.

The catalyst (e.g. palladium-tin) remaining on the wall surface of the through holes is activated before performing the electroless plating. More specifically, the catalyst is activated by dissolving the tin through immersion in organic acid salt which is marketed as an activating agent for plating catalyst. The porous resin film in which a catalyst is adhering to the inner wall surface of the through holes is immersed in an electroless plating solution, and thereby the conductive metal (plating particles) can be precipitated only to the inner wall surface of the through holes where the catalyst is adhering. In this way, tubular electrodes are formed. Examples of the conductive metal include copper, nickel, silver, gold, nickel alloy, etc. However, in the case where high conductivity is needed, it is preferable to use copper.

When an expanded porous PTFE membrane is used, plating particles are extracted in the beginning in a sticking manner to the resin portion (mainly fibrils) that is exposed on the wall surface of the through holes in the expanded porous PTFE membrane, and therefore the adhering condition of the conductive metal can be adjusted by controlling the plating time. By controlling the plating to a suitable quantity, a conductive metal layer can be formed in the wall surface of the through holes in the condition where the porous structure is maintained, and conductivity (anisotropic conductivity) in the film thickness direction by means of tubular electrodes can be afforded without compromising the resiliency of the film thickness direction.

The thickness of the resin portion of the fine structure (for example, the thickness of fibrils of the expanded porous PTFE membrane) is preferably 10 µm or less, more preferably 5 µm or less, and yet more preferably 1 µm or less. The particle diameter of the conductive metal is preferably about 0.001 to 5 µm. The adhesion quantity of the conductive metal is preferably controlled to about 0.01 to 4.0 g/ml in order to maintain the porous structure and the resiliency.

The conductive part (tubular electrode) made as described above is preferably protected with an antioxidant or covered with a precious metal or precious metal alloy in order to prevent oxidation and enhance electrical contactability. The precious metal is preferably palladium, rhodium, or gold from the viewpoint of small electrical resistance. The thickness of the covering layer is preferably 0.005 to 0.5 µm, and more preferably 0.01 to 0.1 µm. For example, in the case of covering the conductive part with gold, it is effective to conduct immersion gold plating after covering the conductive metal layer with nickel in about 8 nm thickness.

If an expanded porous PTFE membrane is used as the porous resin film, the tubular electrodes are formed in a structure such that the conductive metal particles adhere to the fibrils in the wall surface of the through holes. When a stress in the thickness direction is applied to this porous fluororesin substrate, the stress is eased as a result of decrease in distance between fibrils, and the structure of the tubular electrode is maintained without being destroyed. Therefore, the tubular electrodes hardly suffer from degradation when compressive force is repeatedly applied to the expanded porous PTFE substrate.

The tubular electrode generally has a structure in which the conductive metal adheres only to the wall surface of the through holes provided in the thickness direction in the porous fluororesin film. However, a lid member consisting of conductive metal may be provided by controlling electroless plating quantity or by performing electrolytic plating in addition to electroless plating so as to blockade one or both of the two opening ends of the tubular electrode. If the plating quantity is increased, plating particles grow from the edge of the opening end, thereby blockading the opening end. Another way of blockading an opening end without increasing the quantity of the conductive metal adhering to the wall surface of the through holes is a method in which a highly viscous paste including conductive metal particles is applied to the opening end. If the opening end of the tubular electrode is closed with a lid formed of a conductive material by these methods, the contact area between the tubular electrode of the porous fluororesin substrate and a circuit electrode and/or an electrode of a semiconductor chip can thereby be increased.

In addition to such tubular electrodes as mentioned above, it is possible to form electrodes and circuits in various shapes in the porous resin substrate used in the present invention. For example, electrodes and/or circuits can be formed using a photolithography technology on the copper foil layer of a substrate which is prepared by laminating a copper foil on the surface of a porous resin film. Another method for making electrodes or circuits is such that a plating catalyst is applied to a porous resin film in the same pattern as the shape of the electrodes or the circuits and using the plating catalyst, the electrodes or the circuits are formed by electroless plating or the combination of electroless plating and electrolysis plating. Yet another method is such that electrodes and/or circuits are formed by forming a plating layer of conductive metal on the surface of one or both sides of a porous resin substrate and using the photolithography technology.

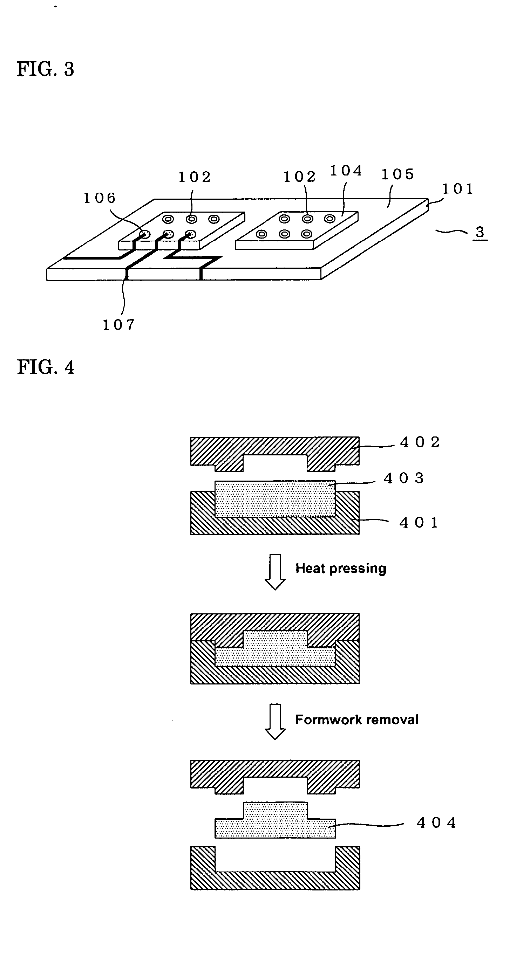

The porous resin substrate generally has a functional part in which electrodes and/or circuits are provided, but it may also have circuits formed in an area around the functional part. For example, circuits can be provided on the height-altered part as shown in Fig. 3.

### 3. Porous resin substrate:

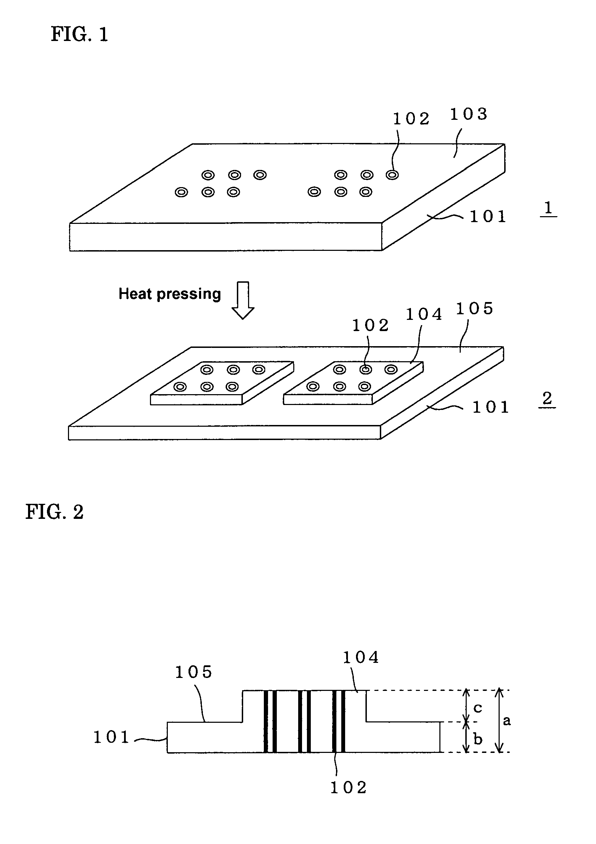

An example of manufacturing method of a porous resin substrate of the present invention will be described with reference to Fig. 1. Figure 1 schematically shows a manufacturing process of a porous resin substrate comprising a porous resin film in which a functional part including a plurality of electrodes (tubular electrode; conductive part) is provided and in which a height-altered part having a height lower than the height of the functional part is formed in an area surrounding the functional part.

A porous resin substrate 1 is prepared by: first, providing a plurality of through holes at the required points of a porous resin film 101 according to a method as described above; and next, adhering a conductive metal to the resin portion of the inner wall surface of each through hole so as to form a conductive part (tubular electrode) 102. In this porous resin substrate 1, a plurality of tubular electrodes 102 collectively constitute the functional part. The number and the arrangement pitch of the tubular electrodes can appropriately be set corresponding to the number and the arrangement pitch of the electrodes of a circuit device or an electric inspection equipment to which the porous resin substrate is electrically connected.

The number of the functional part is not limited, although two functional parts including a plurality of tubular electrodes are shown in Fig. 1. A porous resin substrate in which a number of functional parts are provided may be prepared so that it may be cut into discrete porous resin substrates each including its functional part. The porous resin substrate may be processed to form a height-altered part and subsequently cut into a plurality of porous resin substrates each having its respective functional part.

A part 103 where the porous resin film does not have the conductive part (electrode) exists in an area around the functional part. A height-altered part 105 is formed in an area around the functional part by heat pressing the porous resin substrate 1 shown in Fig. 1. The functional part 104 having a plurality of conductive parts 102 has a prominent structure.

Figure 2 shows a sectional view of an example of porous resin substrate having one functional part. A height level difference is a difference c (a-b=c) in the case of a>b, where a represents the height of the functional part 104 provided in the porous resin film, and b represents the height of the height-altered part 105. The height b of the height-altered part is generally 30 to 95 %, preferably 40 to 90 %, and more preferably 50 to 80 %, of the thickness a of the porous resin film. If the height b of the height-altered part is too high, the height level difference c becomes too short, which results in difficulty in achieving conductance by low loading. When the height b of the height-altered part is too low, the resiliency of the entire porous resin substrate might be compromised, or deformation might be caused during heat pressing.

The method of forming a height-altered part is not particularly limited; however a heat pressing method is preferable. In the heat pressing method, using two molds 401 and 402 as shown in Fig. 4, for example, a porous resin substrate 403 is put in the lower mold 401. The upper mold 402 is heat pressed to engage onto the lower mold 401. By adjusting the shape of the upper mold 402, the shape of the height-altered part and the height of the height level difference can be controlled. In the porous resin film, the height level difference is caused at the part which has been heated and compressed by the heat press. When the molds are removed after the heat pressing, a porous resin substrate 404 having a height level difference is obtained.

The heating temperature during the heat pressing is a temperature which is lower than the decomposition temperature of a resin material constituting a porous resin substrate and which can be set appropriately according to the kind of the resin used. In the case where the base film is an expanded porous fluororesin film such as an expanded porous PTFE membrane, the heating temperature is generally 200 to 320 °C, and preferably 250 to 310 °C. The pressure is a pressure at which the upper mold and the lower mold engage with each other. The pressure application time period can be set appropriately according to the kind of the resin material under the conditions where the shape of the height-altered part is fixed. In the case where the base film is an expansion porous fluororesin such as an expanded porous PTFE membrane, a sufficient pressure application time is generally 100 to 1000 seconds, and preferably 200 to 800 seconds, but not limited to this.

In the case where the oxidation deterioration of electrodes (conductive part, tubular electrode) might occur due to heat during the heat pressing, it is preferable to form a conductive part by the above-mentioned method after a height-altered part is formed in the porous resin film. In this case, to manufacture a porous resin substrate by the above-mentioned method, after the process of Step 1 in which a resin layer is laminated as a mask layer on both sides of the porous resin film so as to form a three layer laminated body, a process of forming a height-altered part in the porous resin film by heat-pressing the laminated body is performed, and subsequently the above-mentioned Steps 2 to 5 are performed.

That is, a porous resin substrate including a height-altered part having a height different from the height of a functional part is produced by a method comprising: Step 1 in which, by a heat pressing method, a height-altered part is formed in an area around the region to constitute the functional part of a porous resin film, the height-altered part having a height lower than the height of the region to constitute the functional part, or a region having a height lower than the height of the neighboring region is formed in the region to constitute the functional part; and Step 2 of forming electrodes or circuits or both of them in the region to constitute the functional part.

The height of a functional part having a height lower than the height of the neighboring region is generally 30 to 95 %, preferably 40 to 90 %, and more preferably 50 to 80 %, of the thickness a of the porous resin film. If the height of the functional part is too high, the height level difference becomes too short, which results in difficulty in achieving conductance by low loading. When the height of the functional part is too low, the resiliency of the entire porous resin substrate might be compromised, or deformation might be caused during heat pressing.

To form the height-altered part, the other method than the pressing method may be adopted. For example, a machining method such as cutting work may be adopted as the other method. Also, the height-altered part can be formed with a light ablation method.

In a porous resin substrate 3, as shown in Fig. 3, circuits 107 can be provided extending from electrodes 106 onto the height-altered part. Such circuits can be formed by the above-mentioned method or the like. Figure 3 show an example in which two functional parts 104 are provided, and it is possible to cut so as to have one functional part. If circuits 107 are provided in the height-altered part, it is possible to restrain the electrodes and/or circuits of each porous resin substrate from touching unnecessarily when a plurality of the porous resin substrates are stacked.

It is possible to make a multilayer substrate by stacking a plurality of porous resin substrates of the present invention. In this case, the respective layers can be united by thermal fusion bonding or by using an adhesive.

In the above-described examples of a porous resin substrate, the height-altered part having a height lower than the height of a functional part of a porous resin film is formed in an area around the functional part. However, the height-altered part is not always required to surround the functional part and may be formed in an optional part, provided that it exists in an area around the functional part. Also, the height of the functional part can be made lower than the height of the height-altered part. Providing a height-altered part allows decreasing of the load applied to achieve conduction in the film thickness direction of a tubular electrode. It is preferable to provide the height-altered part in the whole area in an area around the functional part. Although it is preferable to form a height-altered part only on the surface of one side of a porous resin film, it is possible to provide the height-altered part on both sides of the porous resin film.

### Advantageous Effect of the Invention

In a porous resin substrate according to the present invention, the functional part of a porous resin film which includes electrodes and/or circuits can be formed, for example, in a prominent structure, and consequently it is unnecessary to apply a load to the area in which no functional part is formed. Therefore, the porous resin substrate of the present invention can achieve conduction efficiently with low compressive loading. In a porous resin substrate of the present invention, the mutual contact of circuits can be restrained when a multilayer substrate is manufactured by stacking a plurality of the porous resin substrates. As a result of making the height of a functional part lower than the height of the neighboring region so that the functional part has a depressed structure in the porous resin substrate, it is possible to make a tubular electrode to achieve conduction in the thickness direction mainly by means of loading applied only to an area around the functional part.

### Example

In the following, the present invention will be explained more specifically raising an example, but it is not intended to limit the present invention to this example.

### Example 1

An expanded porous PTFE sheet having a porosity of 60 %, a mean pore size of 0.1 µm, and a thickness of 30 µm was laminated on both surfaces of a base film consisting of an expanded porous PTFE membrane having a porosity (ASTM-D-792) of 60 %, a mean pore size of 0.1 µm, a bubble point of 150 kPa (isopropylalcohol, measured according to ASTM-F-316-76), and a thickness of 600 µm. A sample piece thus prepared was put between two sheets of stainless boards having a thickness of 3 mm, and was subjected to heat treatment at 350 °C for 30 minutes while loading was applied thereto. After the heating, the sample piece was quenched by water applied on the top of the stainless board, and thus a laminated body of expanded porous PTFE membrane having fusion-bonded three layers was obtained.

The expanded porous PTFE laminated body prepared as described above was cut off into a 40 mm square piece. The sample piece thus prepared was heat pressed using a mold shown in Fig. 4, (heating temperature of 300°C, pressing time of 600 seconds) and thereby a height-altered part having a height level difference of 300 µm and a width of 10 mm in the height level difference was formed in the circumferential part of a base film having a thickness of 600 µm. (The circumferential part of the expanded porous PTFE sheet laminated on the base film is also depressed.)

With a drill operating under the conditions of turning speed of 100,000 /min. and a feed speed of 0.01 mm/rev, through holes having a diameter of 250 µm φ were formed at a pitch of 1 mm at a plurality of points in the region not heat-pressed of the laminated body. The laminated body in which through holes were thus formed was immersed in ethanol for 1 minute to be made hydrophilic, and thereafter it was subjected to degreasing treatment by being immersed for 4 minutes at a temperature of 60°C in a dilution of 100 ml/L of Melplate PC-321 made by Meltex Inc. Furthermore, the laminated body was immersed in 10 % sulfuric acid for 1 minute, and subsequently immersed as a pre-dip for 2 minutes in a solution prepared by dissolving Enplate PC-236 (made by Meltex Inc.) at a rate of 180 g/L in 0.8 % hydrochloric acid.

Moreover, the laminated body was immersed for 5 minutes in a solution prepared by dissolving Enplate PC-236 (made by Meltex Inc.) at a rate of 150 g/L in a solution which was prepared by dissolving Enplate activator 444 (made by Meltex Inc.) by 3 %, Enplate activator additive by 1 %, and hydrochloric acid by 3 %, and thereby catalyst particles were adhered to the surface of the laminated body and the wall surface of the through holes. Next, the laminated body was immersed in a 5 % solution of Enplate PA-360 (made by Meltex Inc.) for 5 minutes to perform the activation of palladium catalyst nucleus. Thereafter, the mask layer in the first and third layers were peeled off and an expanded porous PTFE membrane in which catalyst palladium particles adhered only to the wall surface of the through holes was obtained.

The expanded porous PTFE membrane thus obtained was immersed for 20 minutes, while sufficiently air stirred, in an electroless copper plating solution prepared by Melplate Cu-3000A (made by Meltex Inc.), Melplate Cu-3000B, Melplate Cu-3000C and Melplate Cu-3000D respectively 5 %, and Melplate Cu-3000 stabilizer by 0.1 %, and thereby electrical conductivity was afforded by means of copper particles only to the wall of the through holes of 250 µm φ.

Next, gold plating was performed in order to prevent rusting and to improve contactability with circuit board electrodes. The gold plating was conducted by immersion gold from nickel in the following method. The expanded porous PTFE membrane, in which copper particles were adhered to the wall surface of the through holes, was immersed as a pre-dip for 3 minutes in an Activator Aurotech SIT additive (made by Atotech) (80 ml/L), and subsequently immersed, for 1 minute for adding a catalyst, in a solution prepared by Aurotech SIT activator conc. (125 m1/L), Activator Aurotech SIT additive (80ml/L) made by Atotech. Moreover, it was immersed for 1 minute in Aurotech SIT Postdip (25ml/L) made by Atotech. In this way, a catalyst was adhered onto copper particles.

Next, the base film was immersed for 5 minutes in an electroless nickel plating solution prepared with sodium hypophosphite (20 g/L), trisodium citrate (40 g/L), ammonium borate (13 g/L), and nickel sulfate (22 g/L), and thereby copper particles were coated with nickel. Thereafter, the base film was immersed for 5 minutes in an immersion gold plating solution made by Meltex [Melplate AU-6630A (200 ml/L), Melplate AU-6630B (100 mI/L), Melplate AU-6630C (20 ml/L), gold sodium sulfite solution (1.0 g/L as gold)] so that the conductive metal particles were coated with gold.

It was confirmed that in the expanded porous PTFE substrate thus prepared, tubular electrodes had conduction when loading was applied to the functional part since the functional part was prominent, and the original shape was recovered due to the resilient property when the loading was removed. This expanded porous PTFE substrate was fixed to the electrode region of electrical inspection equipment after adjustment of the positional relationship so as to connect each conductive part with each electrode of the electrical inspection equipment. Thus, the electrical inspection of semiconductor chips could repeatedly be performed, achieving conduction by means of low loading.

### Industrial applicability

The porous resin substrate of the present invention can suitably be applied in the fields of connectors and interposers for use as, for example, an anisotropic conductive film used in electrical connection between two circuit devices, or an anisotropic conductive film used in performing an electrical inspection for semiconductor integrated circuit devices, printed circuit boards, etc.

## Claims

1. A porous resin substrate comprising a porous resin film having at least one functional part including electrodes or circuits, or both of them, where the porous resin film has a height-altered part, the height of the height-altered part being different from the height of the functional part.

2. A porous resin substrate according to claim 1, where the electrodes are tubular electrodes structured such that conductive metal is adhered to the inner wall surfaces of the through holes made piercing in a thickness direction from a first surface to a second surface of the porous resin film.

3. A porous resin substrate according to claim 2, where the adhering of conductive metal to the inner wall surfaces of the through holes is made by means of electroless plating or the combination of electroless plating and electrolytic plating.

4. A porous resin substrate according to claim 2, where the functional part is a region including a plurality of the tubular electrodes.

5. A porous resin substrate according to claim 4, where the plurality of tubular electrodes are arranged in a pattern corresponding to the number and arrangement pitch of the electrodes of a circuit device or an electric inspection equipment to be connected with the porous resin substrate.

6. A porous resin substrate according to claim 1, where the height-altered part is formed in an area around the functional part.

7. A porous resin substrate according to claim 1, where the height-altered part is formed in an area surrounding the functional part.

8. A porous resin substrate according to claim 1, where the height of the height-altered part is lower than the height of the functional part.

9. A porous resin substrate according to claim 7, where the height of the functional part is equivalent to the thickness of the porous resin film and the height-altered part having a height lower than the height of the functional part has a height equivalent to 30 to 95 % of the thickness of the porous resin film.

10. A porous resin substrate according to claim 1, where the height of the height-altered part is higher than the height of the functional part.

11. A porous resin substrate according to claim 10, where the height of the functional part is equivalent to 30 to 95 % of the thickness of the porous resin film, and the height of the height-altered part is a height equivalent to the thickness of the porous resin film.

12. A porous resin substrate according to claim 1, where the height-altered part is formed in one surface of the porous resin film.

13. A porous resin substrate according to claim 1, where circuits extending from electrodes or circuits or both of them provided in the functional part are provided on the height-altered part.

14. A porous resin substrate according to claim 1, where the porous resin film is a porous fluororesin film.

15. A porous resin substrate according to claim 14, where the porous resin film is an expanded porous PTFE membrane.

16. A porous resin substrate according to claim 15, where the expanded porous PTFE membrane has a porosity of 20 to 80 % and a mean pore size of 10 µm or less.

17. A porous resin substrate according to claim 1, where the porous resin film has a thickness of 20 to 3000 µm.

18. A multilayer substrate made by stacking a plurality of porous resin substrates specified in any one of claims 1 to 17.

19. A method of manufacturing a porous resin substrate, the porous resin substrate including a height-altered part and a functional part, the height-altered part having a height different from the height of a functional part, the method comprising: Step 1 of forming by a heat pressing method the height-altered part in an area around a region to constitute the functional part, the height-altered part having a height lower than the height of the region to constitute the functional part, or forming by the heat pressing method a region having a height lower than the height of the neighboring region in the region to constitute the functional part; and Step 2 of forming electrodes or circuits or both of them in the region to constitute the functional part.

20. A method of manufacturing a porous resin substrate, the method comprising heat pressing by a heat pressing method the porous resin substrate made of a porous resin film so as to form a height-altered part in an area around a functional part, the porous resin film including at least one functional part having electrodes or circuits or both of them.
